Europäisches Patentamt

European Patent Office

Office européen des brevets

(19)

(11) **EP 0 954 105 A1**

(12) **EUROPÄISCHE PATENTANMELDUNG**

(43) Veröffentlichungstag:
03.11.1999 Patentblatt 1999/44

(51) Int. Cl.⁶: **H03L 7/197**

(21) Anmeldenummer: 98107870.2

(22) Anmeldetag: 29.04.1998

(84) Benannte Vertragsstaaten:
AT BE CH CY DE DK ES FI FR GB GR IE IT LI LU MC NL PT SE
Benannte Erstreckungsstaaten:
AL LT LV MK RO SI

(71) Anmelder:
SIEMENS AKTIENGESELLSCHAFT
80333 München (DE)

(72) Erfinder:
• Korbacher, Richard, Dipl.-Ing. (FH)
82178 Puchheim (DE)
• De Ceulaer, Bart, Dipl.-Ing.
2200 Noorderwijk (BE)
• Maes, Guido, Indust.-Ing. (TH)
3945 Ham (BE)

(54) **Phasenregelkreis mit gebrochenem Teilverhältinis**

(57) Phasenregelkreis mit einem gesteuerten Oszillator (VCO), dem als Steuersignal das über ein Filter (FIL) geführte Ausgangssignal ($x_{en}$) eines Phasenkomparators (EXO) zugeführt ist, wobei dem Phasenkomparator einerseits das Ausgangssignal ($x_{in}$) eines Vorwärtsteilers (VWT) für ein Referenzsignal ($x_{ref}$, $f_{ref}$) und andererseits das Ausgangssignal ($x_{out}$) eines Rückwärtsteilers (RWT) für das Ausgangssignal ($x_{VCO}$, $f_{VCO}$) des gesteuerten Oszillators zugeführt ist, und bei welchem zumindest ein Teiler (RWT) als Fraktionalteiler ausgebildet ist, dessen Teilerfaktor für unterschiedliche, vorgebbare Zeitabschnitte unterschiedliche, vorgebbare, ganzzahlige Werte (A, A+1) annehmen kann, wobei der Mittelwert dem gewünschten, im allgemeinen rationalen Teilerfaktor (M) entspricht.

Fig. 7

EP 0 954 105 A1

**Beschreibung**

Die Erfindung bezieht sich auf einen Phasenregelkreis, mit einem gesteuerten Oszillator, dem als Steuersignal das über ein Filter geführte Ausgangssignal eines Phasenkomparators zugeführt ist, wobei dem Phasenkomparator einerseits das Ausgangssignal eines Vorwärtsteilers für ein Referenzsignal und andererseits das Ausgangssignal eines Rückwärtsteilers für das Ausgangssignal des gesteuerten Oszillators zugeführt ist.

In digitalen Übertragungs- und Vermittlungssystemen müssen alle im Datenfluß befindlichen Netzelemente synchronisiert werden. Dazu werden üblicherweise Phasenregelkreise, abgekürzt meist PLL, benutzt, welche die Frequenz eines lokalen Taktes so nachregeln, daß diese identisch mit der Frequenz eines zugeführten Referenztaktes ist bzw. zu diesem in einem konstanten Verhältnis steht. Durch die Dimensionierung der Phasenregelkreise können bestimmte Eigenschaften, wie z. B. Eigenjitter, Jitterübertragungsverhalten, Jitterverträglichkeit etc. festgelegt werden. Ein Parameter, der diese Eigenschaften wesentlich bestimmt, ist der Teilerfaktor in der Rückkoppelschleife des Phasenregelkreises. Dieser Teilerfaktor ist nach dem Stand der Technik bei Phasenregelkreisen immer ganzzahlig und man ist, da der Referenztakt und der lokale Takt zum Phasenvergleich auf die gleiche Frequenz geteilt werden müssen, bei der Dimensionierung dieser Teilerfaktoren stark eingeschränkt. Dadurch können auch die Eigenschaften des Phasenregelkreises oft nicht wie gewünscht vorgewählt werden.

Eine Aufgabe der Erfindung ist die Schaffung eines Phasenregelkreises, bei welchem trotz einfachem und billigem Aufbau die genannten Nachteile nicht vorhanden sind.

Diese Aufgabe wird mit einem Phasenregelkreis der eingangs genannten Art gelöst, bei welchem erfindungsgemäß zumindest ein Teiler als Fraktionalteiler ausgebildet ist, dessen Teilerfaktor für unterschiedliche, vorgebbare Zeitabschnitte unterschiedliche, vorgebbare, ganzzahlige Werte annehmen kann, wobei der Mittelwert dem gewünschten, im allgemeinen rationalen Teilerfaktor entspricht.

Die Erfindung ermöglicht eine große Freiheit bei der Dimensionierung des Phasenregelkreises, beispielsweise die Wahl einer hohen Referenzfrequenz, wodurch sich eine große Bandbreite der Jitterübertragungsfunktion realisieren läßt, praktisch unabhängig von den Frequenzverhältnis zwischen Referenztakt und lokalem Takt. Dadurch läßt sich weiters auch der Eigenjitter dämpfen und es können Oszillatoren mit niedrigerer Güte, somit preiswerte Oszillatoren eingesetzt werden.

Bei einer zweckmäßigen Variante ist vorgesehen, daß der Teilerfaktor als Funktion dreier ganzzahliger Werte zu M=A+B/C dargestellt ist. Durch einen solchen, einfach aufgebauten Teilerfaktor können in der Praxis alle geforderten Teilerwerte erreicht werden.

Von Vorteil ist es im Hinblick auf möglichst wenige zusätzliche Störungen, falls das Änderungsmuster des Teilerfaktors ein pseudostatistisches ist. Auch kann es nicht zuletzt aus diesem Grunde dabei nützlich sein, falls sich das pseudostatistische Muster in einer Periode wiederholt, welche der Frequenz des gesteuerten Oszillators gebrochen durch den gewünschten Teilerfaktor entspricht. Falls das Änderungsmuster des Teilerfaktors eine Zufallsverteilung aufweist, ergeben sich überhaupt keine zusätzlichen unerwünschten Spektrallinien.

Eine praxisbewährte Ausführung ist dadurch gekennzeichnet, daß der Phasenkomparator ein EXOR-Gatter ist.

Prinzipiell kann einer der beiden Teiler oder jeder Teiler als Fraktionalteiler ausgebildet sein, doch ergibt sich die höhere Flexibilität, falls jener Teiler als Fraktionalteiler ausgebildet ist, dessen Eingangssignal die höhere Frequenz aufweist.

Die Erfindung samt weiteren Vorteilen ist im folgenden anhand von Ausführungsbeispielen näher erläutert, die unter Bezugnahme auf die Zeichnung beschrieben werden. In der Zeichnung zeigen

Fig. 1     einen Phasenregelkreis nach dem Stand der Technik,

Fig. 2     schematisch einen bei der Erfindung verwendeten Entscheidungsalgorithmus,

Fig. 3     ein Beispiel des pseudostatistischen Phasenfehlers,

Fig. 4     eine Verfeinerung des Entscheidungsalgorithmus,

Fig. 5     in einem Diagramm ein Beispiel des Signalverlaufs der Referenzfrequenz, der Oszillatorfrequenz, des pseudostatistischen Rückkopplungsignals und der Abtastpunkte,

Fig. 6     den Phasenfehler an dem Phasenkomparator,

Fig. 7     ein Blockschaltbild einer ersten Ausführungsform eines Phasenregelkreises nach der Erfindung,

Fig. 8     ein Blockschaltbild einer Ausführungsform eines Phasenregelkreises nach dem Stand der Technik,

Fig. 9     die Übertragungsfunktion des EXOR-Phasenkomparators

Fig. 10    das Ausgangsspektrum des Phasenkomparators bei einem Ausführungsbeispiel.

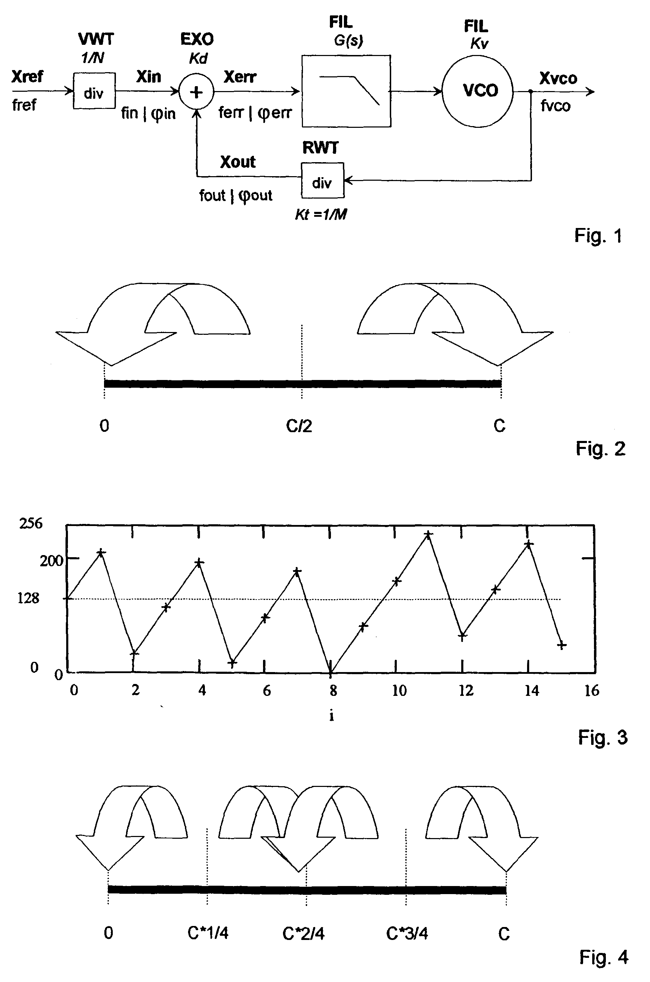

Bei dem im folgenden beschriebenen Ausführungsbeispiel wird zunächst auf Fig. 1 bezug genommen, welche das Blockschaltbild eines Standardphasenregelkreises zeigt, das auch für den Stand der Technik zutrifft. Bei dem nachstehend auch numerisch in Betracht gezogenen Beispiel wird eine Referenzfrequenz $f_{ref}$ von 2,048 MHz und eine Frequenz $f_{VCO}$ des spannungsgesteuerten Oszillators VCO von 17,28 MHz angenommen. In Fig. 1 ist ersichtlich, daß die Referenzfrequenz $f_{ref}$ einem Vorwärtsteiler VWT, der durch N dividiert, zugeführt wird und von hier als Signal $x_{in}$ mit der Phase $\varphi_{in}$ und mit Frequenz $f_{in}$ einem EXOR-Phasenkomparator EXO, welchem ein Filter FIL mit der Übertragungsfunktion G(s) folgt. Das Ausgangssignal dieses Filters steuert den Oszillator VCO mit einem Übertragungsfaktor Kv an, wobei die Ausgangsfrequenz des Oszillators VCO mit $f_{VCO}$ bezeichnet ist. In der Rückkoppelschleife befindet sich ein Rückwärtsteiler RWT, mit einem Teilerfaktor $\frac{1}{M}$ und das Ausgangssignal $x_{out}$ dieses Teilers mit der Phase $\varphi_{out}$ und mit der Frequenz $f_{out}$ wird dem zweiten Eingang des EXOR-Phasenkomparators EXO zugeführt. Der Übertragungsfaktor dieses Phasenkomparators ist mit Kd bezeichnet, und es ist anzumerken, daß zwar hier ein EXOR-Gatter verwendet wird, daß ebensogut jedoch auch andere Phasenkomparatoren verwendbar sind.

Eine der Haupteigenschaften einer PLL liegt darin, daß hochfrequenter Jitter der Referenzfrequenz $f_{ref}$ ausgefiltert wird. Die Jittertransferfunktion einer PLL ist ein Tiefbaßfilter mit einer Grenzfrequenz $\alpha$, auch genannt die Bandbreite der PLL. Diese Grenzfrequenz ist gleich der Gesamtverstärkung bei offenem Kreis, nämlich: $\alpha = Kd \cdot g \cdot Kv \cdot Kt$ (rad/s) .

Dabei ist mit G die Gleichspannungsverstärkung des Tiefbaßfilters bezeichnet, die zwar nicht fest ist, jedoch nur wenig geändert werden kann. Eine niedrigere Verstärkung verringert den Abstimmbereich des Oszillators VCO, wogegen eine höhere Verstärkung ein Begrenzen am Eingang des Oszillators VCO bewirken kann. Die Verstärkung Kd ist bei einem EXOR-Phasenkomparator fest und kann mit

$$Kd = \frac{V_{dd}}{\pi} \text{ (V/rad)}$$

angegeben werden, wobei mit $V_{dd}$ die Betriebsspannung bzw. der Ausgangsspannungsbereich angegeben ist.

Die Verstärkung des Oszillators VCO ist in den meisten Fällen konstant bzw. durch andere Beschränkungen festgelegt. Die Rückkopplungsverstärkung Kd kann nicht höher als ein spezieller Wert sein, der durch die höchste gemeinsame Frequenz von $f_{ref}$ und $f_{VCO}$ definiert ist.

Die obigen Angaben weisen darauf hin, daß die maximale Grenzfrequenz $f_c$ der Jittertransferfunktion durch äußere Umstände beschränkt ist. Der einzige Parameter, der sich leicht ändern läßt ist der Rückkopplungsverstärkungsfaktor

$$Kt = \frac{1}{M}.$$

Kt kann aber nicht höher als eine bestimmte Grenze sein. Von dem Beispiel ausgehend, bei welchem die Referenzfrequenz $f_{ref}$ 2,048 MHz und die VCO-Frequenz $f_{VCO}$ 17,28 MHz beträgt, liegt die höchste gemeinsame Frequenz ($f_{in}$ und $f_{out}$) zwischen $f_{ref}$ und $F_{VCO}$ bei 128 kHz, was zu einem Teilerfaktor M = 135 führt. Geht man weiters von einer Versorgungsspannung von 5 V aus, einem Filterverstärkungsfaktor G = 1 und einer VCO-Verstärkung Kv = 100 kHz/V so wird die höchste Grenzfrequenz $\alpha$=0,13 Hz.

Will man nun von einer VCO-Ausgangsfrequenz von 17,28 MHz in diesem Beispiel auf eine Komparatoreingangsfrequenz von 2,048 MHz gelangen, so benötigte man einen Rückkoppelungs-Teilungsfaktor M von M=8,4375.

Im folgenden wird nun das Prinzip der Erfindung erläutert, wobei man davon ausgeht, daß bei dem genannten Beispiel das Ausgangssignal des gesteuerten Oszillators VCO mit einer Frequenz von $f_{VCO}$ durch eine pseudostatistische Folge, die aus 9 x 8 und 7 x 9, zusammen somit 135 geteilt wird. So kann der durchschnittliche Teilungsfaktor von 8,4375 genau erzeugt werden und die durchschnittliche Ausgangsfrequenz $f_{out}$ wird genau 2,048 MHz sein, wenngleich der Augenblickswert niemals 2,048 MHz beträgt. Wenn ein Teilungsfaktor A · B benötigt wird, wobei A der ganzzahlige und B der nicht ganzzahlige Wert ist, so wird pseudostatistisch durch Werte A und A + 1 in einem solchen Verhältnis geteilt, daß der durchschnittliche Teilungsfaktor genau A · B beträgt.

Bei dem EXOR-Phasenkomparator wird der resultierende Phasenfehler ($\varphi_{in}$ - $\varphi_{out}$) nie genau gleich Null sein, sondern er wird pseudostatistische positive und negative Werte zeigen. Der durchschnittliche Phasenfaktor wird jedoch Null sein, sieht man von dem Gleichstrom-Phasenoffset von 90° ab der normalerweise bei einem EXOR-Phasenkomparator vorliegt. Der genannte Phasenfehler führt zur Einführung eines pseudostatistischen Jitter an dem Ort des Phasenkomparators.

Es versteht sich, daß die optimale Sequenz von A und A+1 Divisionen erzeugt werden muß, um die Eingangsfrequenz der PLL so genau wie möglich zu halten. Dadurch wird der geringste Jitterpegel bei dem Phasenkomparator eingeführt. Natürlich will man gleichzeitig zu einer so allgemein wie möglichen Lösung gelangen.

Im folgenden wird der Rückkoppelungs-Teilungsfaktor als Funktion von drei ganzen Zahlen A, B, C wie folgt dargestellt: $T_d = A + B/C$ .

Dabei ist A ein ganzzahliger Wert und B/C ein rationaler Wert. In dem Beispiel konnte man setzen: A = 8, B = 112, C = 256.

Der Algorithmus zur Erzeugung eines optimalen pseudostatistischen Musters wird nachgehend beschrieben. Der erste Schritt, nämlich die Division durch A, würde zu einem Fehler von B/C oder, in anderen Worten, zu B bezogen auf C führen. Teilt man jedoch durch A + 1, so entsteht ein Fehler von 1-B/C oder, bezogen auf C, von C-B.

Um zu einer Entscheidung zu gelangen, ob man besser durch A oder durch A + 1 teilen soll, muß man erkennen, ob B (oder C - B) geringer ist, d.h. mit anderen Worten, daß man untersuchen muß, ob $B < \frac{c}{2}$ oder $B > \frac{c}{2}$. Für die nächsten Schritte merkt man sich den Fehler von dem vorhergehenden Schritt und summiert dazu den aktuellen Fehler. Die nächsten Entscheidungen werden dann aufgrund des akkumulierten Fehlers aller vorhergehenden Entscheidungen getroffen. Es wird durch A geteilt, falls der akkumulierte Fehler kleiner als $\frac{c}{2}$ ist und durch A + 1 in dem anderen Fall, was in Fig. 2 veranschaulicht ist.

Dieses Vorgehen erzeugt automatisch das optimale pseudostatistische Muster, das zur bestmöglichen Approximierung der Referenzfrequenz benötigt wird. Der Akkumulator wird den für den jeweiligen Augenblick erwarteten Phasenfehler zwischen $f_{in}$ und $f_{out}$ beinhalten. Das Schaubild des Phasenfehlers bis zu C = 256 ist in Fig. 3 veranschaulicht, wobei sich das pseudostatistische Muster nach 16 Divisionen wiederholt.

Im allgemeinen wird das Muster sich immer nach einer festen Anzahl von Divisionen wiederholen, sodaß die Länge der Musterwiederholung gleich der Zeitperiode der Komparatorfrequenz ist, die vorläge, wenn man nur durch ganzzahlige Werte dividiert (bei diesem Beispiel eine Periode von 128 kHz oder 7,8 μsec).

Der Vorteil der Erfindung geht unmittelbar daraus hervor, daß durch die Erhöhung der Komparatorfrequenz von 128 kHz auf 2,048 MHz auch die Bandbreite des Phasenregelkreises um einen Faktor 16 von 0,13 Hz auf 2,08 Hz erhöht wurde.

Im folgenden wird noch unter Bezugnahme auf Fig. 4 eine zweckmäßige Weiterbildung der Erfindung beschrieben, bei welcher nicht nur die Anstiegsflanke der VCO-Frequenz zur Erzeugung der besten Näherung verwendet wird, sondern auch deren fallende Flanke. Der resultierende Entscheidungsalgorithmus ist in Fig. 4 wieder veranschaulicht, wobei ersichtlich ist, daß hier die "Unschärfe" nicht mehr $\frac{c}{2}$ ist, sondern $\frac{c}{2}$ beträgt.

Eine weitere Möglichkeit ist die Anwendung der Erfindung auf integrierende Phasenregelkreise. Bei vielen Phasenregelkreisen wird gefordert, daß nicht nur die Frequenz synchronisiert ist, sondern daß auch der Phasenfehler zwischen Eingang und Ausgang innerhalb spezifischer Grenzen liegt (in CCIT-Empfehlungen MRTIE = Maximum Relative Time Interval Error genannt). Dabei müssen auch Temperaturänderungen sowie Alterungen in Betracht gezogen werden.

Gemäß der Regeltheorie wird dieses Problem dadurch gelöst, daß nicht nur eine proportionale sondern auch eine integrale Rückkopplung verwendet wird. Dies bedeutet, daß die Eingangsspannung des VCO die Summe des augenblicklichen Phasenfehlers (proportionaler oder P-Teil) und des Langzeitintegrals des Phasenfehlers (integraler oder I-Teil) ist. Auf diese Weise werden in den Integralteil sämtliche Temperatur- und Alterungsfehler akkumuliert, sodaß der P-Teil genau bei 0° (bei 90° für einen EXOR-Phasenkomparator) bleiben kann.

In vielen Fällen wird eine analoge Lösung verwendet, wobei das Kreisfilter ein integrierendes Filter ist. Wenn jedoch sehr hohe Zeitkonstanten benötigt werden, oder wenn es erforderlich ist, daß der Integrator für eine Hold-Over-Funktion abgeschaltet wird, erfordert dies eine digitale Ausführung.

Allerdings hat eine digitale Realisierung typischerweise den Nachteil, daß der Phasenfehler lediglich in Vielfachen der Abtastfrequenz (hier der VCO-Frequenz) gemessen werden kann. Um kleine MRTIE-Werte zu erhalten, erfordert dies sehr hohe Abtastfrequenzen.

Die im Zusammenhang mit der Erfindung beschriebene Schaltung kann in einfacher Weise dahingehend erweitert werden, daß sie die Verwirklichung kleiner MRTIE-Werte ermöglicht, ohne daß hohe Abtastfrequenzen benötigt werden. Um zu entscheiden, ob die PLL von ihrem 90°-Punkt abweicht, müßte man die Referenzfrequenz bei genau 90° abtasten. Dies ist jedoch nicht möglich, da man nur bei Vielfachen des VCO-Taktes abtasten kann. Bei den bisher besprochenen Ausführungsbeispiel der Erfindung werden in dem Rückkopplungssignal bei 90° und 270 ° Flanken erzeugt. Die zur Steuerung des Integrators benötigten Abtastpunkte liegen jedoch bei 0° und 180°. Es müßten daher vier Flanken für jede Periode der Referenzfrequenz $f_{ref}$ erzeugt werden. Bei dem Beispiel mit 17,28 MHz und 2,048 MHz bedeutet dies, daß man $f_{VCO}$ durch (17,28/2,048) • 1/4 = 2,109375 (=2+28/256) teilen muß.

Sodann werden die Resultate dazu verwendet, abwechselnd einen Abtastpunkt zur Abtastung des Referenztaktes und einer Flanke des pseudostatistischen 2,048 MHz-Rückkopplungssignals zu erzeugen.

Man weiß jedoch im vorhinein, ob die Abtastpunkte zu früh oder zu spät sein werden. D. h. man weiß mit anderen Worten im vorhinein, ob der von $f_{ref}$ genommene Abtastwert hoch oder niedrig sein soll. Falls die Abtastpolarität korrekt ist, wird der Integrationszähler ungeändert gelassen, andererseits wird er in Abhängigkeit von der Polarität des Abtastwertes erhöht oder verringert.

Man sieht auch aus Fig. 3, daß die Zeitdifferenz zwischen den Abtastpunkten und den Referenzflanken gleichfalls ein pseudostatistisches Muster aufweisen. Dies führt zu einer abschnittsweise linearen Funktion des Integrators. Kleine MRTIE-Werte werden lediglich eine Integratoraktualisierung je Periode der Referenz bewirken, wogegen größere MRTIE-Werte auch zu Mehrfach-Aktualisierungen führen.

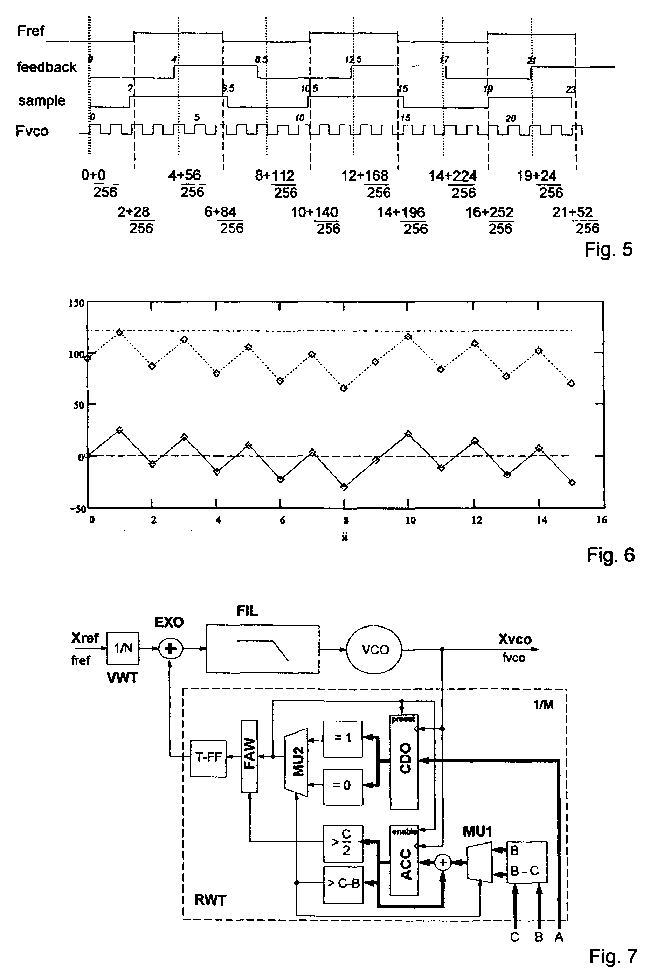

Für das Beispiel $f_{ref}$ = 2,048 MHz und $f_{VCO}$ = 17,28 MHz ist ein Muster der Referenzfrequenz, des Rückkopplungsignales, des Abtastsignals und des VCO-Ausgangsignals in Fig. 5 gezeigt.

Eine praktisch realisierbare Ausführung der Erfindung ist in Fig. 7 dargestellt, wobei - soweit möglich - gleiche Bezugszeichen wie bei Fig. 1 verwendet wurden. Der Rückwärtsteiler RWT enthält eine logische Struktur, welche die Durchführung der oben genannten Rechenoperationen ermöglicht. Es können dabei die Werte A, B und C eingegeben werden. Auf das Beispiel mit einer Referenzfrequenz von 2,048 MHz und einer VCO-Frequenz von 17,28 MHz zurückkommend sieht man, daß N=1 bleiben kann und $f_{VCO}$ durch M=8,4375 dividiert werden muß. Dabei wird $f_{VCO}$ einem Abwärtszähler CDO sowie einem Akkumulator ACC als Takt zugeführt, wobei an dem Eingang des Abwärtszählers CDO die Größe A liegt. Über die genannten Entscheidungskriterien wird auch eine Flankenauswahl FAW angesteuert, welcher ein Binärteiler TFF nachgeschaltet ist. Ein Multiplexer MU1 trifft die Auswahl zwischen B und B-C in Abhängigkeit von der Entscheidung, ob der Ausgang des Akkumulators ACC größer als (C-B) ist oder nicht. Von dieser Entscheidung wird auch ein zweiter, dem Abwärtsteiler CDO nachgeschalteter Multiplexer MUL gesteuert, dessen Ausgang einerseits als preset-Signal für den Abwärtszähler CDO und andererseits als enable-Signal für den Akkumulator ACC dient. Man muß daher Werte für A, B und C so wählen, daß der Binärteiler TFF im Mittel gemäß 8,4375/2=4,21875 toggelt. Dies erreicht man mit der Wahl von A=4, B=56 und C=256. Dadurch wird die Ausgangsfrequenz des Teilers RWT gleich 2,048 MHz, was zu den optimalen Eigenschaften der PLL führt.

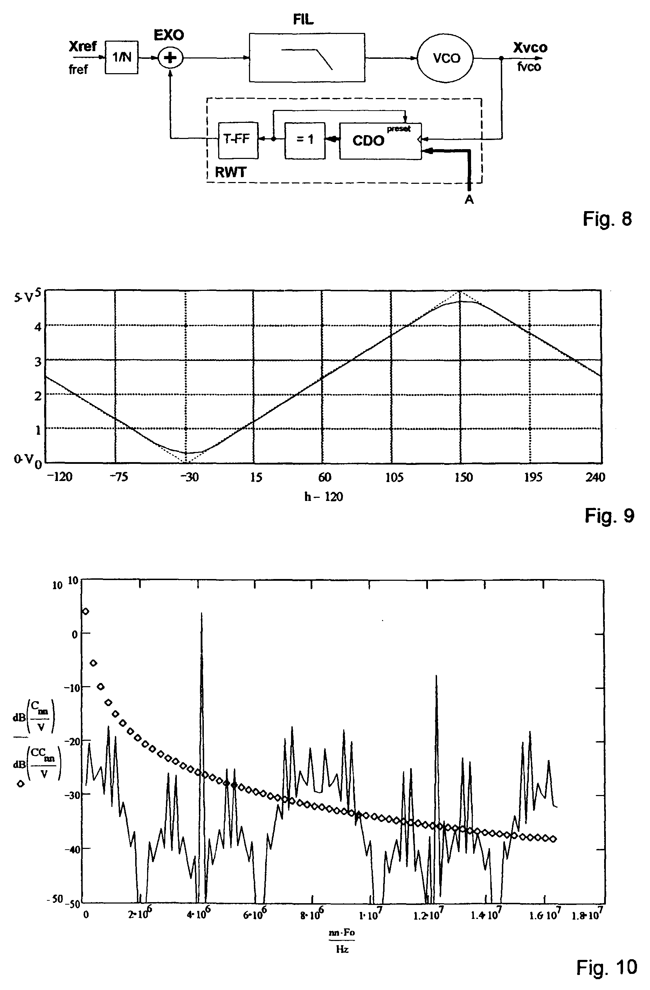

Der eben beschriebenen Ausführungsform sei zum Vergleich kurz eine Ausführung nach dem Stand der Technik gemäß Fig. 8 gegenübergestellt. Bei gleichen Frequenzen $f_{ref}$ und $f_{out}$ muß man nun bis auf eine Frequenz von 128 kHz an dem Phasenkomparator EXO teilen, da dies der größte gemeinsame Teiler von $f_{ref}$ und $f_{out}$ ist. Somit ist N=16, und es ergibt sich bei gleicher Verwendung eines Binärteilers TFF A=135/2. Da daraus resultierend A nicht ganzzahlig ist, muß man bei dieser Ausführung auf 64 kHz herabgehen, um N=32 und A=270 zu erhalten. Dadurch werden aber die wichtigsten Eigenschaften des Phasenregelkreises um einen Faktor 32 schlechter als bei der Ausführung nach Fig. 7.

Aufgrund des pseudostatistischen Phasenfeh-lers zwischen $f_{in}$ und $f_{out}$ wird die Übertragungsfunktion des EXOR-Phasenkomparators geändert. In der Darstellung nach Fig. 6 ist der Phasenfehler in nsec für zwei unterschiedliche Phasenoffsets zwischen $f_{in}$ und $f_{out}$ eingezeichnet. Die punktierte Linie bezeichnet 90° der Referenzfrequenz (hier 2,048 MHz), wogegen das untere pseudostatistische Muster einen durchschnittlichen Phasenfehler gleich 0 besitzt. Für das obere Muster ist der durchschnittliche Phasenfehler positiv. Man sieht, daß der Durchschnitt linear mit dem Phasen-Offset zwischen $f_{in}$ und $f_{out}$ ansteigt.

Wenn der Phasen-Offset eine bestimmte Grenze übersteigt, übersteigen einige Punkte des pseudostatistischen Musters die 90°-Grenze des EXOR-Phasenkomparators und beginnen zu fallen. Bei noch höherem Phasen-Offset werden mehr Punkte die Grenze übersteigen und bei bestimmten Phasen-Offset werden alle Punkte absinken statt steigen. Dies führt zu der in Fig. 9 gezeigten Übertragungskurve für den EXOR-Phasenkomparator. Dabei ist in Fig. 9 die Übertragungskurve für einen EXOR-Phasenkomparator in einer üblichen PLL punktiert eingezeichnet. Man erkennt, daß die Übertragungskurve im wesentlichen linear bleibt, jedoch bei den ± 90°-Phasen-Offset-Punkten abgerundet ist.

Bei einer üblichen PLL ist das Ausgangssignal des EXOR-Phasenkomparators ein Rechtecksignal mit 50 % Tastgrad und der doppelten Frequenz der Komparatorfrequenz. Bei dem hier angenommenen Beispiel ist es ein 256 kHz Rechtecksignal. Sein Spektrum besitzt abnehmende Linien bei allen ungeraden Vielfachen von 256 kHz. Die Schaltung nach der Erfindung erzeugt hingegen ein Rechtecksignal mit einer durchschnittlichen Frequenz von 4,096 MHz und einem pseudostatistischen Tastverhältnis. Dies führt zu einem Spektrum, das wesentlich mehr Gehalt bei hohen Frequenzen hat, jedoch mit weniger starken Linien. Jedenfalls können keine Linien unterhalb von 128 KHz liegen, da dies die Wiederholfrequenz des pseudostatistischen Musters ist.

Fig. 10 zeigt ein Spektrum nach dem Stand der Technik, das mit Rhombenpunkten eingezeichnet ist und ein Spektrum nach einer erfindungsgemäßen Ausführung. Man erkennt deutlich, daß bei niedrigen Frequenzen die Amplituden erheblich unter jenen bei einer Schaltung nach dem Stand der Technik liegen. Der Anteil bei den höheren Frequenzen ist wiederum nicht kritisch, da er leicht durch den Tiefpaß beseitigt werden kann.

## Patentansprüche

1. Phasenregelkreis, mit einem gesteuerten Oszillator (VCO), dem als Steuersignal das über ein Filter (FIL) geführte Ausgangssignal ($x_{en}$) eines Phasen-komparators (PHK) zugeführt ist, wobei dem Pha-senkomparator einerseits das Ausgangssignal ($x_{in}$) eines Vorwärtsteilers (VWT) für ein Referenzsignal ($x_{ref}$, $f_{ref}$) und andererseits das Ausgangssignal ($x_{out}$) eines Rückwärtsteilers (RWT) für das Ausgangssignal ($s_{VCO}$, $f_{VCO}$) des gesteuerten Oszillators zugeführt ist,
**dadurch gekennzeichnet**,
daß zumindest ein Teiler (RWT) als Fraktionalteiler ausgebildet ist, dessen Teilerfaktor für unterschiedliche, vorgebbare Zeitabschnitte unterschiedliche, vorgebbare, ganzzahlige Werte (A, A+1) annehmen kann, wobei der Mittelwert dem gewünschten, im allgemeinen rationalen Teilerfaktor (M) entspricht.

2. Phasenregelkreis nach Anspruch 1,
   **dadurch gekennzeichnet**,
   daß der Teilerfaktor als Funktion dreier ganzzahliger Werte (A, B, C) zu M=A+B/C dargestellt ist.

3. Phasenregelkreis nach Anspruch 1 oder 2,
   **dadurch gekennzeichnet**,
   daß das Änderungsmuster des Teilerfaktors ein pseudostatistisches ist.

4. Phasenregelkreis nach Anspruch 3,
   **dadurch gekennzeichnet**,
   daß sich das pseudostatistische Muster in einer Periode wiederholt, welche der Frequenz ($f_{VCO}$) des gesteuerten Oszillators (VCO) gebrochen durch den gewünschten Teilerfaktor (M) entspricht.

5. Phasenregelkreis nach Anspruch 1 oder 2,
   **dadurch gekennzeichnet**,
   daß das Änderungsmuster des Teilerfaktors eine Zufallsverteilung aufweist.

6. Phasenregelkreis nach einem der Ansprüche 1 bis 5,
   **dadurch gekennzeichnet**,
   daß der Phasenkomparator (EXO) ein EXOR-Gatter ist.

7. Phasenregelkreis nach einem der Ansprüche 1 bis 6,
   **dadurch gekennzeichnet**,
   daß jener Teiler (RWT) als Fraktionalteiler ausgebildet ist, dessen Eingangssignal die höhere Frequenz aufweist.

**VWT**
*1/N*

**EXO**
*Kd*

**FIL**
*G(s)*

**FIL**
*Kv*

Xref ——→ div ——→ **Xin** ——→ (+) ——→ **Xerr** ——→ [G(s)] ——→ (VCO) ——→ **Xvco** ——→
fref                    fin | φin          ferr | φerr                              fvco

**Xout** ←—————— **RWT** ←——
div

fout | φout          *Kt =1/M*

Fig. 1

Fig. 2

256

200

128

0

0   2   4   6   8   10   12   14   16
i

Fig. 3

0      C*1/4    C*2/4    C*3/4    C

Fig. 4

Fig. 5

Fig. 6

Fig. 7

Fig. 8

Fig. 9

Fig. 10

| | Europäisches Patentamt | EUROPÄISCHER RECHERCHENBERICHT | | Nummer der Anmeldung EP 98 10 7870 |

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| X | EP 0 641 083 A (SGS-THOMSON) 1. März 1995 * Spalte 5, Zeile 3 - Spalte 6, Zeile 57; Abbildungen 1-5 * --- | 1-7 | H03L7/197 |
| X | US 5 021 754 A (W. SHEPHERD ET. AL.) 4. Juni 1991 * Spalte 2, Zeile 55 - Spalte 4, Zeile 38; Abbildung 1 * --- | 1-7 | |
| X | WO 91 16759 A (MOTOROLA INC,) 31. Oktober 1991 * Seite 6, Zeile 20 - Seite 10, Zeile 24; Abbildungen 2,3 * --- | 1-7 | |
| X | US 5 576 666 A (R. RAUVOLA) 19. November 1996 * Spalte 4, Zeile 16 - Spalte 6, Zeile 59; Abbildung 2 * --- | 1-7 | |
| X | WO 91 07824 A (CARLETON UNIVERSITY) 30. Mai 1991 * Seite 6, Zeile 1 - Seite 9, Zeile 2; Abbildung 1 * ----- | 1-7 | RECHERCHIERTE SACHGEBIETE (Int.Cl.6) H03L |

Der vorliegende Recherchenbericht wurde für alle Patentansprüche erstellt

| Recherchenort DEN HAAG | Abschlußdatum der Recherche 25. September 1998 | Prüfer Butler, N |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
........................................................................
& : Mitglied der gleichen Patentfamilie, übereinstimmendes Dokument

EPO FORM 1503 03.82 (P04C03)